## Europäisches Patentamt

## European Patent Office

## Office européen des brevets

(11) Publication number: **0 049 112**
**B1**

# EUROPEAN PATENT SPECIFICATION

(45) Date of publication of patent specification: **04.03.87**

(51) Int. Cl.⁴: **G 11 C 19/08**

(21) Application number: **81304400.5**

(22) Date of filing: **24.09.81**

(54) Method and apparatus for controlling writing and reading of data in cassette memories.

(30) Priority: **25.09.80 JP 133305/80**

(43) Date of publication of application:
**07.04.82 Bulletin 82/14**

(45) Publication of the grant of the patent:
**04.03.87 Bulletin 87/10**

(84) Designated Contracting States:
**CH DE FR GB LI**

(56) References cited:
**FR-A-2 356 985**
**US-A-4 138 695**

**4TH IECI ANNUAL CONFERENCE
PROCEEDINGS, "Industrial applications of
microprocessors", 20th-22nd March 1978,
pages 77-82, published by IEEE, New York,
USA. C. D. ETHRIDGE et al.: "Microprocessor
data-input-control unit for mark century
numerical contouring control"**

(73) Proprietor: **FANUC LTD**
**3580, Shibokusa Aza-Komanba Oshino-mura
Minamitsuru-gun Yamanashi 401-05 (JP)**

(72) Inventor: **Nozawa, Ryoichiro**
**12-1-2105, Sarugaku-cho
Shibuya-ku Tokyo (JP)**
Inventor: **Kiya, Nobuyuki**
**Yokokawa-cho-jutaku 13-106 108, Yokokawa-
cho
Hachioji-shi Tokyo (JP)**

(74) Representative: **Billington, Lawrence Emlyn
et al
HASELTINE LAKE & CO Hazlitt House 28
Southampton Buildings Chancery Lane
London WC2A 1AT (GB)**

(56) References cited:
**ELECTRONIC DESIGN, vol. 27, no. 24,
November 1979, pages 172-175, Rochelle Park,
USA. G. NEENO: "Serial of major/minor loop?
Choose the bubble memory to match the
application"**

Courier Press, Leamington Spa, England.

## Description

This invention relates to a method and apparatus for controlling the writing and reading of data for cassette memories.

In numerical control devices having an internal memory for storing a part program, it is conventional practice to use a paper tape as a storage medium for writing the part program into the memory and for preserving the information which is stored in the memory. A tape reader and tape puncher are connected to the numerical control device, the former for transferring data from the tape to the internal memory, and the latter for reversing the process. A system of this type which relies upon a paper tape storage medium is not entirely satisfactory since the paper tape has a comparatively short life, is difficult to handle and does not always provide the desired reliability since reading errors are often encountered. Moreover, system costs are raised owing to the provision of the tape reader and puncher.

In recent years cassette memories of the type that rely upon magnetic bubbles and semiconductors or the like have been developed as storage media to replace the older tape configurations. Numerical control systems employing such cassette memories as storage media have been disclosed and put into practical use. An example of a numerical control system using a semiconductor cassette memory in such fashion is disclosed in U.S.P. 4,229,804.

A disadvantage encountered in the conventional numerical control system with a cassette memory storage medium is that the cassette memory cannot be utilized in a truly effective manner. For example, assume that data such as a program for a machining operation is desired to be stored in a blank portion of the cassette memory, but that the blank portion is of insufficient size to permit storage of the entire program. In such case the machining program is stored in a separate or "new" cassette memory, and nothing is written into the blank portion of the former memory. The cassette memory therefore cannot be exploited effectively since the blank portion is wasted, and costs are raised as a result.

In view of the above there is need for a method and apparatus for controlling data read and write operations in a cassette memory wherein a blank portion is not wasted even if it is incapable of storing a single machining program in its entirety. In other words, the prior art does not yet include the above-described method and apparatus which can allow a cassette memory to be exploited fully by enabling data to written into even the foregoing blank portion.

When magnetic tapes are used as the storage media in a computer system, a file compilation method does exist in which a plurality of files may be stored on a single reel of magnetic tape, one magnetic tape unit comprising one so-called volume (see "Introduction to File Compilation", published July 25, 1980, p.p. 9—11, author is Masaki Yamada). Nevertheless, though a volume might have a blank portion, data is not stored there when the files cannot be written in the blank portion in their entirety, and the blank portion is ultimately wasted.

The following publication is of interest, i.e. 4th IECI ANNUAL CONFERENCE PROCEEDINGS, "Industrial applications of microprocessors", 20th—22nd March 1978, pages 77—82, published by IEEE, New York, USA, C.D. ETHRIDGE et al.: "Microprocessor data-input-control unit for mark century numerical contouring control".

It discloses a data transfer from a magnetic tape cassette to a numerical control device. A particular character stored on the tape identifies the end of one cassette and that additional data is on the next cassette.

FR—A—2 356 985 discloses a method and apparatus in accordance with the precharacterising portions of attached claims 1 and 6.

US—A—4 138 695 discloses that the end of a tape used for oral dictation may be signalled, but this does not assist either in overcoming the problem faced by the present inventors.

The following publication also is of interest, i.e. ELECTRONIC DESIGN, vol. 27, no. 24, November 1979, pages 172—175, Rochelle Park, USA, G. Neeno: "Serial or major/minor loop? Choose the bubble memory to match the application". This discloses the general proposal that bubble memories may be utilised in numerical control applications.

According to one aspect of the invention there is provided a method of controlling data write and read operations for a cassette memory used as an auxiliary memory in a numerical control system which includes a numerical control device, the cassette memory itself, and a write/read control apparatus provided between the numerical control device and the cassette memory for writing numerical control data into the cassette memory and for reading numerical control data out of the cassette memory, said method being characterised by:

dividing a file into a plurality of blocks each comprising a predetermined number of bytes, this step being executed in the operation of writing data into the cassette memory, being a bubble cassette memory, by the write/read control apparatus, wherein one file constitutes one input unit of data written into the bubble cassette memory from the numerical control device;

adding a control byte to the head part of each of said plurality of blocks;

sensing whether the amount of remaining storage space in the bubble cassette memory is equivalent to one block of data; and

writing a code, indicating a shift to a subsequent bubble cassette memory, in the last control byte stored in the bubble cassette memory, this step being executed when the remaining storage space in the bubble cassette memory is sensed to be equivalent to one block of data.

According to another aspect of the invention there is provided a data write/read control apparatus, provided or for provision between a numerical control device and a cassette memory to be used as an auxiliary memory for a numerical control system, for writing numerical control data into the cassette memory and for reading numerical control data out of the cassette memory, characterised in that said cassette memory is a bubble cassette memory and in that said apparatus comprises:

means for dividing one input unit of data, written into the bubble cassette memory from the numerical control device, into a plurality of blocks each comprising a predetermined number of bytes;

means for adding a control byte to the head part of each of said plurality of blocks;

means for discriminating whether the amount of remaining storage space in the bubble cassette memory is equivalent to one block of data; and

means for writing a code, indicating a shift to a subsequent bubble cassette memory, into the control byte of the last block.

Preferred examples of the present invention may provide a method and apparatus for controlling data write and read operations in a cassette memory to permit effective utilization of the memory, particularly to avoid wasting of a blank portion of a cassette memory even when an entire machining program cannot be stored in the blank portion.

According to a development of the present invention, there is provided a method and apparatus for controlling data write and read operations in which, when a blank portion for storing data is no longer available in a cassette memory, means such as a lamp informs the operator to unload the cassette memory and replace it with a new cassette memory to permit the writing of further data.

A development of the present invention may provide a method and apparatus for controlling data write and read operations in which it is possible to readily sense when a blank portion is no longer available in a cassette memory.

A development of the present invention may provide a method and apparatus for controlling data write and read operations in which, in reading data out of a cassette memory, it is possible to readily sense read-out of the final item of data and to provide an indication calling for the exchange of the cassette memory at such time.

Examples of the present invention may be particularly well-suited for application to a bubble cassette memory.

Other features and advantages of examples of the invention will be apparent from the following description taken in conjunction with the accompanying drawings, in which

Fig. 1 is an illustrative view useful in describing an information read operation with regard to a magnetic bubble memory of the type having a major-minor loop configuration;

Fig. 2 is a block diagram of a write/read control apparatus for controlling data write and read operations in a cassette memory in accordance with the invention;

Fig. 3 is an illustrative view useful in describing a configuration of data; and

Fig. 4 is an illustrative view useful in describing a configuration of data in accordance with the present invention.

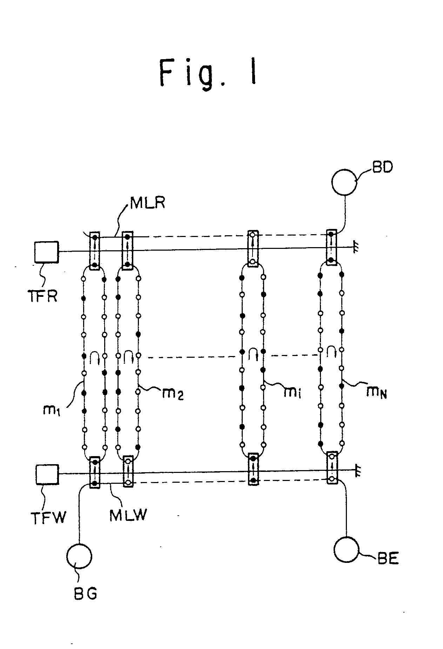

An example of the present invention will be described in connection with the magnetic bubble memory illustrated in Fig. 1. The bubble memory is of the well-known type as disclosed in, for example, the booklet entitled "Fujitsu Bubble Memory Technical Information", 1979, published by Fujitsu Limited. In Fig. 1, $m_1$, m2, $m_i$ ... $m_N$ denote minor loops which are a total of N in number. Each minor loop is a closed loop comprising a bubble domain transfer track of 2M bits. The loops may, for example, consist of a series of T bar patterns. BG denotes a bubble memory generator, BE a bubble eraser, MLR a major line for reading only, and MLW a major line for writing only. The minor loops $m_1$, $m_2$, ..., $m_N$ are arranged with one end adjoining the major line MLR and the other end adjoining the major line MLW. When a transfer command is issued by a transfer site TFR, those bubble domains (indicated by the black circles) at bit positions in the minor loops that are in the transfer area of the read-only major line MLR at that instant are transferred to the major line MLR. On the other hand, when a transfer command is issued by a transfer site TFW, those bubble domains (indicated again by the black circles) which have been written into the write-only major line MLW are transferred to the minor loops $m_1$, $m_2$, ..., $m_N$ at the areas where the minor loops are adjacent the major line MLW.

The process for a read operation takes place as follows. In reading one access unit of stored information comprising N bits, bubble domains in the N-number of minor loops $m_1$, $m_2$, ..., $m_N$ are transferred in parallel to the read-only major line MLR in response to the transfer command. In the magnetic bubble memory of Fig. 1, if we let the information of 2M bits stored in each minor loop $m_i$ (where i = 1, 2, ..., N) be expressed by b(i, 1), b(i, 2), ..., b(i, 2M—1), b(i, 2M), then one access unit of stored information will be taken to mean N-bit information comprising the bits expressed by [b(1, j), b(2, j), ..., b(N, j)], where j = 1, 2, ..., 2M.

The bubble domains which have been transferred to the read-only major line MLR are shifted bit-by-bit successively within the read-only major line MLR to provide an output of serial data. Accordingly, when a bubble detector BD such as one which relies upon magneto-resistance is provided at the exit from the read-only major line MLR, the output data may be read by sensing the absence or presence of the bubble domains. It should be noted that, in a read operation, destructive and non-destructive read operations may be performed. In the destructive read operation, one access unit of the bubble domains in the minor loops $m_1$, $m_2$, ..., $m_N$ is destroyed as it is read. This does not occur in the non-destructive read operation. It is customary for information to be read in such a non-destructive manner.

Thus, in accordance with the foregoing description, stored information is read from the read-only major line MLR, and data is written into the minor loops from the write-only major line MLW. Since the bubble domains are shifted within each of the minor loops $m_i$ in the direction indicated by the arrow, a prescribed access unit of information is read out of the bubble memory, when said access unit arrives at the read-only major line MLR and a prescribed access unit of new information being prepared in the write-only major line MLW is written into the minor loops $m_i$, when the bit positions in the minor loops $m_i$ into which said new information is to be written arrive at the write-only major line MLW. Consequently, in reading data out of the bubble memory, the bit positions in the minor loops $m_i$ which store the data to be read have to be positioned at the transfer locations between the read-only major line MLR and the minor loops and in writing data into the bubble memory, the bit positions in the minor loops $m_i$ into which new information is written have to be positioned at the transfer locations between the write-only major line MLW and the minor loops $m_i$.

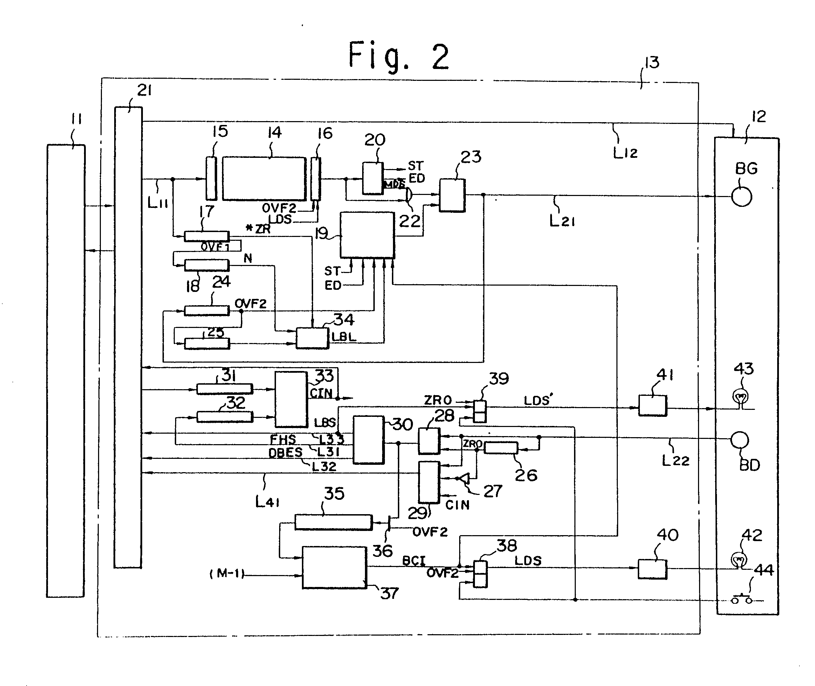

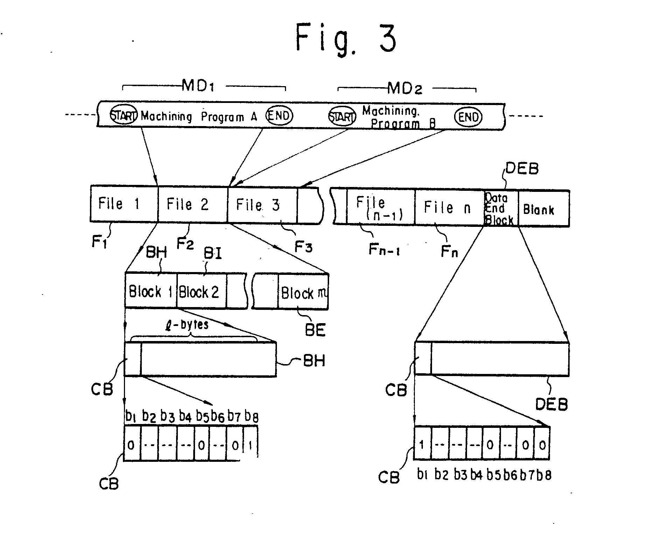

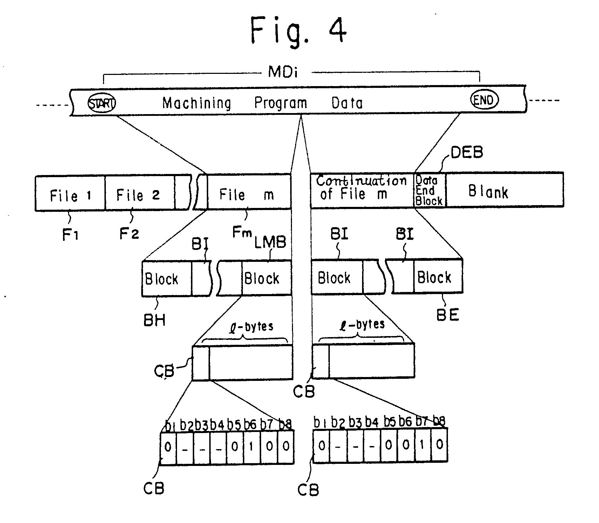

Examples of the present invention will now be described with reference to Figs. 2 through 4. Fig. 2 is a block diagram of a write/read control apparatus, Fig. 3 illustrates a configuration of data, and Fig. 4 illustrates a configuration of data for a case where a single file of data is stored spanning two bubble cassette memories.

Referring first to Fig. 2, there are provided a numerical control device 11, a bubble cassette memory 12 comprising, for example, a magnetic bubble memory of the type having the major-minor loop configuration of Fig. 1, and a write/read control apparatus 13 for writing data into the bubble cassette memory 12, for reading data out of the bubble cassette memory 12, and for controlling the transfer of data between the numerical control device 11 and the bubble cassette memory. A buffer memory 14 temporarily stores a series of machining data, such as a machining program (referred to as a single file), the data being provided continuously by the numerical control device 11. It should be noted that one file of machining data, denoted by $MD_i$ ($i = 1, 2 ...$) in Fig. 3, is composed of a start byte, a number of machining program bytes, and an end byte. One block of data is composed of l bytes, as will be described below. Numeral 15 denotes a write control circuit, and numeral 16 represents a ready control circuit. A byte counter 17 having a capacity of (l—1) bytes is adapted to count up, byte-by-byte, the machining data provided by the numberical control device 11. The output of the byte counter 17 is a signal *ZR which is logical "1" when the content of the counter is non-zero. A counter 18 is operable to count overflow pulses $OVF_1$ issued by the byte counter 17. When the output *ZR of the byte counter 17 is a "0", the value N of the count in counter 18 represents the number of blocks in one file. When *ZR is a "1", (N + 1) represents the number of blocks in one file. This will be described in greater detail below. A control byte generating circuit 19. When one file of machining data $MD_i$ is divided into a number of blocks of (l—1) bytes each, the control byte generating circuit 19 inserts one control byte CB at the beginning or head of each block, as shown in Fig. 3. Each one of the blocks, now in the form of a total of l bytes, is stored in the cassette memory 12. The control byte CB is composed of eight bits $b_1$ through $b_8$, as illustrated in Fig. 3. In one file, a "1" is stored in the eighth bit $b_8$ of the control byte of the beginning or head block BH, a "1" is stored in the fifth bit $b_5$ of the control byte of the last block BE, and a "1" is stored in the seventh bit $b_7$ of the control-byte of an intermediate block BI. Although a multiplicity of files $F_i$ ($i = 1, 2, ...$) are stored in the cassette memory 12, a data end block DEB is written in the cassette memory after the last file $F_n$. A "1" is written in the first bit $b_1$ of the control byte CB of the data end block DEB. Further, in the process of storing in the cassette memory 12 the series of machining data in the form of blocks of l bytes each, there will come a time when only one block of blank space remains in the cassette memory although the block to be stored in said blank space does not complete the data in the machining program. At such time a "1" is written in the sixth bit $b_6$ of the control byte of said block, as shown in Fig. 4. Thus, a "1" will be written in the eighth bit $b_8$ of a control byte of a block if the block is at the head of a file, in the fifth bit $b_5$ of the control byte if the block is the last one in the file, in the seventh bit $b_7$ if the block is an intermediate block, in the first bit $b_1$ if the block is a data end block, and in the sixth bit $b_6$ if the block is to be stored in the last remaining single block storage area of the cassette memory 12.

Connected to the output side of the read control circuit 16 is a decoder 20 which generates a data start signal ST at logical "1" when the data read out of the buffer memory 14 is start data START, a data end signal ED at logical "1" when the read-out data is end data END, and a machining data signal MDS at logical "1" when the read-out data is neither the start nor end data. A control circuit 21 controls the entire cassette memory write/read control apparatus 13. A data combining circuit 23 combines the machining data read out of the buffer memory 14 and the control data produced by the control byte generating circuit 19 and applies the combined data as an input to the bubble generator BG in the cassette memory 12 through a line 21. A byte counter 24 having a capacity of l bytes has its content up-counted by +1 each time one byte of data is obtained from the data combining circuit 23. A counter 25 counts overflow pulses $OVF_2$ generated by the byte counter 24 and indicates the number of blocks in one file. A byte counter 26 having a capacity of l bytes is adapted to count, byte-by-byte, data read through line $L_{22}$ from the bubble detector BD of the cassette memory 12, and to issue a zero signal ZRO at logical "1" when its content is zero. Numeral 27 denotes a NOT gate, and numeral 28 a gating circuit which is opened when the zero signal ZRO is at logical "1", thereby delivering the control data. Numeral 29 denotes a gating circuit which is opened when a coincidence signal CIN, indicative of file retrieval completion which will be described below, is a "1", and the zero signal ZRO is a "0", thereby delivering the machining data (exclusive of the control data). A discrimination circuit 30, connected to the output side of the gating circuit 28, delivers a "1" on line $L_{31}$ when the eighth bit $b_8$ of a control byte is a "1", on line $L_{32}$ when the first bit $b_1$ is a "1", or on line $L_{33}$ when the sixth bit $b_6$ is a "1". In other words, the discrimination circuit 30 examines the input control data arriving through the gating circuit 28 and delivers a file head signal FHS (logical "1") on line $L_{31}$ when the head block BH (see Fig. 3) of a file is read, delivers a data end block signal DBES (logical "1") on the line $L_{32}$ when the data end block DEB is read, or delivers a last block signal LBS (logical "1") on line $L_{33}$ when the block which has been stored in the last single block storage area of the cassette memory 12 is read. Numeral 31 denotes a commanded file location register for storing the location of a file which is desirable (where the "location" of the file means the number of the file, i.e., second, third, ..., from the head or first file). For example, when the numerical control device 11 delivers a file retrieval command which calls for searching the head part of the i-th file, the numerical value $i$ is stored in the commanded file location register 31. Furthermore, when the numerical control device 11 delivers a file retrieval command which calls for searching the head part of the file $F_{i+1}$ following the file $F_i$ which was processed immediately prior thereto, the control circuit 21 adds +1 to the position $i$ of said file which was input or output immediately prior thereto, and the result of this operation (i.e., $i + 1$) is stored in the commanded file location register 31. A current file location register 32 has its content incremented by +1 each time a "1" appears on line $L_{31}$, thereby storing the position of the file which is currently being read. A comparator 33 sends the coincidence signal CIN at logical "1" to the control circuit 21 and to the gating circuit 29 when the commanded file location coincides with the current file location. A comparator circuit 34 compares the contents of the counters 18, 25 and delivers a coincidence signal LBL when the contents coincide.

A block counter 35, having a capacity M, indicates the block number of a storage area in the cassette memory 12 which is having data written into it at that time, that is, the number of the block, from the head or first block, which is being written in said storage area. More specifically, when the data end block DEB is retrieved, the block counter 35 is incremented by +1 each time an item of control data is delivered by the gating circuit 28 and, when data from the numerical control device is being written into the cassette memory 12, the block counter is incremented by +1 each time one block is written (i.e., each time an overflow pulse $OVF_2$ is generated). The number of control data items counted until the data end block DEB is retrieved represents the total number of blocks already written into the cassette memory; hence, the content of the block counter 35 gives the block location, i.e., tells what the number of the block is from the head block, at that location of the cassette memory 12 from which data is currently being read or into which data is currently being written. Numeral 36 denotes an OR gate.

A comparator circuit 37 compares the content of block counter 35 with the value M—1 (where M is the total number of blocks which can be stored in the cassette memory 12), and issues a coincidence signal BCI when M—1 and the counter content are in coincidence. Numeral 38 denotes a flip-flop. When one block of blank space is all that remains in the cassette memory 12 in the course of a data write operation, the comparator circuit 37 generates the coincidence signal BCI in response to which the flip-flop 38 is set. Another flip-flop is shown at numeral 39. When the last block LMB (see Fig. 4) is read out of the cassette memory 12 during a read operation, the discrimination circuit 30 issues the last block signal LBS which sets the flip-flop 39. Numerals 40, 41 designate drivers, 42, 43 denote lamps, and numeral 44 a reset button.

The operation of the present embodiment of the invention will first be described for a case where one file of machining data $MD_1$ (Fig. 3) is entered from the numerical control device 11 and stored in the cassette memory 12.

When the numerical control device 11 sends a new file write command to the control circuit 21, the latter responds by delivering a read command to the cassette memory 12 over line $L_{12}$ so that data is read sequentially from the beginning of the cassette memory and delivered over line $L_{22}$. Since the content of byte counter 26 is zero (ZRO = "1") only when the initial byte (control byte) of a block is read, the control data is passed by the gating circuit 28, which has been opened by the "1" logic from the counter, and is applied to the discrimination circuit 30. The latter determines whether a "1" has been stored in the first bit $b_1$ of the control data which enters every I-th byte of the data being read. In other words, the discrimination circuit 30 determines whether the control data input thereto belongs to the data end block DEB. When the control data is indeed found to have a "1" in the first bit thereof, the discrimination circuit 30 sends the data block end signal DBES (logical "1") to the control circuit 21 over the line $L_{32}$. The control circuit 21, in response to the "1" logic of signal DBES, immediately halts the data read operation. The foregoing completes the processing for preparing the cassette memory into which the new machining data $MD_1$ is to be written. That is to say, in accordance with the foregoing process, the bit positions in the minor loops into which new information is written, are positioned at the transfer locations.

Meanwhile, one file of the machining data, which has been delivered by the numerical control device 11 concurrent with or prior to such processing, is stored in the buffer memory 14. More specifically, as the machining data $MD_1$ is delivered sequentially byte-by-byte through the control circuit 21, the data is stored in the buffer memory 14 by the write control circuit 15. The byte counter 17 concurrently has its content incremented by +1 each time one byte of the machining data (with the exception of the start data and end data) is delivered on line $L_{11}$, the counter 17 issuing the overflow pulse $OVF_1$ when I—1 bits of machining data have been generated and counted. The counter 18 counts the overflow pulses $OVF_1$ from the counter 17 and therefore indicates the number of blocks in the file. Thus, when the content of the byte counter 17 is restored to zero (*ZR = "0"), which occurs when an end byte is generated, the value of the count N in the counter 18 represents the total number of blocks in the file that have entered from the numerical control device; when the content of the byte counter 17 is non-zero (*ZR = "1"), the total number is blocks in the file that have entered from the numerical control device is the value of the count N plus one (i.e., N + 1).

When all of the machining data in one file has been stored in the buffer memory 14, the read control circuit 16 causes the machining data to be read out of the buffer memory 14 sequentially byte-by-byte and applied simultaneously to the decoder 20. Since the initial data is the start data START, the data start signal ST from the decoder 20 is logical "1", while machining data signal MDS and data end signal ED are both logical "0". As a result, the AND gate 22 is closed, so that the start data START cannot be delivered to the data combining circuit 23. Meanwhile, the control byte generating circuit 19, owing to the "1" logic of the data start signal ST, generates the control data having the "1" written in the eighth bit, the control data being coupled to the bubble generator BG in the cassette memory 12 through the combining circuit 24 and line $L_{21}$, whereby the data is written sequentially into the cassette memory from the bit positions in the minor loops which are positioned at the transfer location as mentioned above. Next, since the data which follows the start data is machining data, the machining data signal MDS from the decoder 20 becomes a "1" and remains at that logic level until the end data END arrives. In consequence, (I − 1) bytes of machining data are stored in the cassette memory 12 through the AND gate 22, data combining circuit 23 and line $L_{21}$. In other words, the head block BH of the machining data is written in the cassette memory. Note that it is arranged so that one block of data is written into the cassette memory at one time when the size of one block is taken to be one access unit of the bubble memory.

The byte counter 24 has its content incremented by +1 each time one byte of data is delivered by the data combining circuit 23. Accordingly, when the data combining circuit 23 delivers one byte of machining data and (I − 1) bytes of machining data, or in other words, when the data combining circuit 23 delivers I bytes (one block) of data, the byte counter 24 generates an overflow pulse $OVF_2$. This increments the content of counter 25 by +1 and causes the read control circuit 16 to temporarily halt the reading of data from the buffer memory 14. In addition, the overflow pulse $OVF_2$ causes the control byte generating circuit 19 to deliver the control data having logical "1" written in the seventh bit $b_7$ thereof, this data being coupled to the cassette memory 12 through the data combining circuit 23 and line $L_{21}$. The read control circuit 16 then again reads (I − 1) bytes of machining data out of the buffer memory 14. This data is coupled to, and stored in, the cassette memory 12 through the AND gate 22, data combining circuit 23 and line $L_{21}$. In other words, the second block of the data is written in the cassette memory. Then, in the manner described above, control data having logical "1" written in the seventh bit thereof is written in the cassette memory 12 for every (I − 1) bytes of machining data, thereby to accomplish storage of the third block.

The above operation is repeated to write in the subsequent blocks of machining data. Then, at the instant that the block immediately preceding the last block BE (Fig. 3) of the file is written into the cassette memory 12, the value of the count in counter 25 is N. Note that the value of the count in counter 18 also is N since the total number of blocks in this case is N + 1 and the content of byte counter 17 is non-zero (*ZR = "1"). Accordingly, at the point in time that the block immediately preceding the last block BE is written into the cassette memory 12, the contents of the counters 18, 25 are both N, so that the coincidence circuit 34 produces the coincidence signal LBL at logic level "1". The "1" logic causes the control byte generating circuit 19 to generate the control data having logical "1" written in the fifth bit $b_5$, this data being stored in the cassette memory 12 through the data combining circuit 23 and line $L_{21}$. The machining data of the last block BE is then stored in the cassette memory 12 through the AND gate 22, data combining circuit 23 and Line $L_{21}$.

When the end data END is read out of the buffer memory 14, the decoder 20 delivers the end data signal ED at logical "1". In response to this signal the AND gate 22 is closed and the control byte generating circuit 19 generates control data having logical "1" written in the first bit $b_1$, this data being stored in the cassette memory 12. Thus, the data end block DEB is written in the cassette memory.

Thus, in accordance with the foregoing series of operations, one file of machining data is divided into individual blocks and one byte of control data is inserted at the head of each block before the machining data is stored in the cassette memory 12. In addition, a data end block DEB is written into the cassette memory after the file most recently stored. Note that when a subsequent file is to be written into the cassette memory, said file is written starting from the location of the data end block and then is followed by a data end block of its own.

It will now be described how one file of machining data is read out of the cassette memory 12 and transmitted to the numerical control device.

When the numerical control device 11 issues a retrieval command to search the head part of a file at a file location $i$, the commanded file location $i$ is set in the commanded file location register 31 under the control of the control circuit 21. The control circuit 21 concurrently issues a read command which is sent to the cassette memory 12 over line $L_{12}$ so that data is read from the beginning of the cassette memory. Thus, data is read sequentially from the head file. Since the content of the byte counter 26 is zero (zero signal $ZRO$ = logical "1") only when the initial byte of the block is read, only the control data is applied to the discrimination circuit 30 through the gating circuit 28. The discrimination circuit 30 sends a "1" out on line $L_{31}$ each time it receives an item of control data having a "1" written in the eighth bit $b_8$, each "1" signal incrementing the content of the current file location register 32 by +1. In this manner a "1" will appear on line $L_{31}$ each time an item of control data in the head block is read out, each digital "1" incrementing the content of the current file location register 32 by +1.

The comparator circuit 33 compares the commanded file location $i$ and the current file location and sends the coincidence signal CIN to the control circuit 21 when they are in coincidence. The control circuit 21 responds to the coincidence signal CIN by immediately halting the data read operation. (This is the completion of commanded file retrieval). The foregoing completes the processing for searching the head of the desired file from which data is to be read.

That is to say, in accordance with the foregoing process, the bit positions in the minor loops which store the data to be read, are positioned at the transfer locations.

One file of maching data is now read out of the cassette memory 12 through line $L_{22}$ in the sequence of one byte of control data and $(I - 1)$ bytes of machining data of the first block, one byte of control data and $(I - 1)$ bytes of machining data of the second block and so on.

It should be noted that when the control data is read, the content of byte counter 26 is zero ($ZRO$ = logical "1"), so that the gate 29 is closed and cannot deliver the machining data to the numerical control circuit. On the other hand, when the machining data of $(I - 1)$ bytes is being read, the content of the byte counter 26 ranges from 1 to $(I - 1)$ and is therefore non-zero ($ZRO$ = logical "0"), so that the gating circuit 29 is opened following generation of the coincidence signal CIN (logical "1"). This permits the machining data to be transferred to the numerical control device 11 through line $L_{41}$ and the control circuit 21. Thus, data read out of the cassette memory 12 is transmitted to the numerical control device 11 exclusive of the machining data.

Data is written into and read from the cassette memory 12 in the manner set forth above. During the course of the write operation, however, there are occasions where the cassette memory 12 is filled to capacity before a file can be fully stored in the memory. How data may be written in the memory on such an occasion will now be described.

As data is being written into the cassette memory 12, the content of block counter 35 represents the total number of blocks which have already been written into the memory. That is, in the preparatory processing (retrieval of the data end block DEB) performed prior to the data write operation, the content of the block counter 35 is incremented by +1 each time one byte of control data arrives from the gating circuit 28. Moreover, when data is being written into the cassette memory 12 from the numerical control device 11, the content of the block counter 35 is incremented by +1 each time one block of data is written, i.e., each time an overflow pulse $OVF_2$ is generated.

The comparator circuit 37 constantly compares the content of block counter 35 with the value $M - 1$ ($M$ being the total number of blocks capable of being stored in the cassette memory 12) and produces the coincidence signal BCl when the counter content and $M - 1$ agree. In other words, the coincidence signal BCl is delivered when the blank portion, namely the remaining amount of storage area, of the cassette memory 12 corresponds to one block. The control byte generating circuit 19, responsive to the coincidence signal BCl, generates the control data having logical "1" written in the sixth bit $b_6$ of the control byte. This data is applied as an input to the cassette memory 12 through the data combining circuit 23 and line $L_{21}$, and is written into the last block storage area of the cassette memory. The machining data of $(I - 1)$ bytes is then read out of the buffer memory 14, transmitted through the AND gate 22, data combining circuit 23 and line $L_{21}$ and stored in said last block storage area of the cassette memory. Since the byte counter 24 issues the overflow pulse $OVF_2$ at this time, the content of block counter 35 is restored to zero and flip-flop 38 is set, the latter delivering a lamp drive signal LDS (logical "1") through the driver 40. A cassette exchange indication lamp 42, mounted on the casing (not shown) which houses the cassette memory 12, lights in response to the drive signal LDS. The lighted lamp tells the operator to exchange the cassette for a new one. When the operator loads the new cassette tape and then presses the reset button 44, flip-flop 38 is reset, lamp 42 is extinguished, and the lamp drive signal LDS returns to logical "0". Processing for writing in the remaining data may now begin from the head part of the new cassette memory.

In the reading of data from the cassette memory 12, on the other hand, the discrimination circuit 30 delivers the last block signal LBS (logical "1") on line $L_{33}$ when it senses the control data having the "1" logic written in the sixth bit $b_6$ of the control byte (the "1" logic in the sixth bit $b_6$ in effect signifying a shift to the next cassette). When the signal LBS is generated and the zero signal ZRO from the byte counter 26 goes to logical "1", that is, when the last block LMB (Fig. 4) which includes the control data (the "1" in bit $b_6$) is read out of the cassette memory, the control circuit 21 halts the data read operation. At the same time, flip-flop 39 is set, and a lamp drive signal LDS' is delivered through the driver 41. The drive signal lights a cassette memory exchange indication lamp 43. The lighted lamp 43 tells the operator to load the next cassette. When the operator does so and then presses the reset button 44, flip-flop 39 is reset and lamp 43 is extinguished. The control circuit 21 then permits data to begin being read from the head part of the new cassette memory. It should be noted that a single lamp may be used rather than the two lamps 42, 43 described above.

The foregoing examples of the present invention allow a bubble cassette memory to be filled in its entirety with stored data so that effective use of the memory can be maximized. Since data which cannot fit in a single cassette memory can be processed on the memory control device side, processing on the NC side is simplified and control can be effected in the same manner as used to control other I/O units, such as a tape reader and tape puncher. Furthermore, since the externally provided lamps are lit to indicate when a cassette memory should be exchanged during a data write or read operation, the operator's job is greatly facilitated.

In the preferred embodiment described above, data to be transferred from the numerical control device to the cassette memory is stored temporarily in the buffer memory. Such an arrangement is not strictly essential, however, and the data can be applied directly to the cassette memory.

In general terms, there has been described and illustrated a data/write/read control apparatus, provided between a numerical control device and a bubble cassette memory for writing data into the bubble cassette memory and for reading data out of the bubble cassette memory, as well as a method of controlling the data write/read operations. In a data write operation, a file is divided into a plurality of blocks, each comprising a predetermined number of bytes, one file constituting one input unit of data written into the bubble cassette memory from the numerical control device. A control byte is added to the head part of each block and, when the amount of remaining storage space in the bubble cassette memory is equivalent to one block of data, a code, indicating a shift to a subsequent bubble cassette memory, is written in the control byte of the last block stored in the bubble cassette memory. An external indication is given instructing when to exchange the bubble cassette memory for the subsequent cassette. In a data read operation, the code indicating cassette exchange is sensed, whereupon an external indication is given instructing exchange of the cassette.

As many apparently widely different embodiments of the present invention can be made without departing from the spirit and scope thereof, it is to be understood that the invention is not limited to the specific embodiment thereof except as defined in the appended claims.

**Claims**

1. A method of controlling data write and read operations for a cassette memory used as an auxiliary memory in a numerical control system which includes a numerical control device, the cassette memory itself, and a write/read control apparatus, provided between the numerical control device and the cassette memory, for writing numerical control data into the cassette memory and for reading numerical control data out of the cassette memory, said method being characterised by:

dividing a file into a plurality of blocks each comprising a predetermined number of bytes, this step being executed in the operation of writing data into the cassette memory, being a bubble cassette memory, by the write/read control apparatus, wherein one file constitutes one input unit of data written into the bubble cassette memory from the numerical control device;

adding a control byte to the head part of each of said plurality of blocks;

sensing whether the amount of remaining storage space in the bubble cassette memory is equivalent to one block of data; and

writing a code, indicating a shift to a subsequent bubble cassette memory, in the last control byte stored in the bubble cassette memory, this step being executed when the remaining storage space in the bubble cassette memory is sensed to be equivalent to one block of data.

2. A method of controlling data write and read operations for a cassette memory according to claim 1, further including a step of indicating externally that a bubble cassette memory is to be exchanged when the amount of remaining storage space in the bubble cassette memory is zero.

3. A method of controlling data write and read operations for a cassette memory according to claim 1 or claim 2, in which said one input unit of data is a single numerical control program.

4. A method of controlling data write and read operations for a cassette memory according to claim 1, 2 or 3, further including the steps of:

sensing a code, indicating a shift to said subsequent bubble cassette memory, in the operation of reading data out of the bubble cassette memory, and

indicating externally that a bubble cassette memory is to be exchanged when said code is sensed.

5. A method of controlling data write and read operations for a cassette memory according to any preceding claim, in which numerical control data is written into the bubble cassette memory in one block units.

6. A data write/read control apparatus, provided or for provision between a numerical control device and a cassette memory to be used as an auxiliary memory for a numerical control system, for writing numerical control data into the cassette memory and for reading numerical control data out of the cassette memory, characterised in that said cassette memory is a bubble cassette memory and in that said apparatus comprises:

means for dividing one input unit of data, written into the bubble cassette memory from the numerical control device, into a plurality of blocks each comprising a predetermined number of bytes;

means for adding a control byte to the head part of each of said plurality of blocks;

means for disciminating whether the amount of remaining storage space in the bubble cassette memory is equivalent to one block of data; and

means for writing a code, indicating a shift to a subsequent bubble cassette memory, into the control byte of the last block.

7. A data write/read control apparatus according to claim 6, further comprising means for lighting a lamp upon detection of the fact that the amount of remaining storage space in the bubble cassette memory is zero.

8. A data write/read control apparatus according to claim 6 or claim 7, further including:

means for sensing a code, indicating a shift to said subsequent bubble cassette memory, in the operation of reading data out of the bubble cassette memory, and

means for indicating externally that a bubble cassette memory is to be exchanged in response to the detection of said code.

**Patentansprüche**

1. Verfahren zum Steuern von Datenschreib- und Datenleseoperationen für einen Kassettenspeicher, der als Hilfsspeicher in einem numerischen Steuersystem benutzt wird, das eine numerische Steuereinrichtung, den Kassettenspeicher selbst und eine Schreib/Lese-Steuereinrichtung enthält, die zwischen der numerischen Steuereinrichtung und dem Kassettenspeicher angeordnet ist, zum Einschreiben von numerischen Steuerdaten in den Kassettenspeicher und zum Auslesen von numerischen Steuerdaten aus dem Kassettenspeicher, gekennzeichnet durch das Aufteilen einer Datei in eine Vielzahl von Blöcken, wovon jeder aus einer vorbestimmten Anzahl von Bytes besteht, wobei dieser Schritt innerhalb der Operation des Einschreibens von Daten in den Kassettenspeicher, der ein Blasen-Kassettenspeicher ist, durch die Schreib/Lese-Steuereinrichtung ausgeführt wird und wobei eine Datei eine Eingabeeinheit von Daten darstellt, die in den Blasen-Kassettenspeicher von der numerischen Steuereinrichtung her eingeschrieben werden,

das Addieren eines Steuerbytes zu dem Kopfteil jedes aus der Vielzahl von Blocken,

das Prüfen, ob die Größe des verbleibenden Speicherplatzes in dem Blasen-Kassettenspeicher einem Block von Daten äquivalent ist und

das Einschreiben eines Codes, der ein Überwechseln zu einem nachfolgenden Blasen-Kassettenspeicher anzeigt, in das letzte Steuerbyte, das in dem Blasen-Kassettenspeicher gespeichert ist, wobei dieser Schritt ausgeführt wird, wenn der verbleibende Speicherplatz in dem Blasen-Kassettenspeicher als einem Block von Daten äquivalent erfaßt wird.

2. Verfahren zum Steuern von Datenschreib- und Datenleseoperationen für einen Kassettenspeicher nach Anspruch 1, das ferner einen Schritt zum externen Anzeigen der Tatsache enthält, daß ein Blasen-Kassettenspeicher zu wechseln ist, wenn die Größe des verbleibenden Speicherplatzes in dem Blasen-Kassettenspeicher Null ist.

3. Verfahren zum Steuern von Datenschreib- und Datenleseoperationen für einen Kassettenspeicher nach Anspruch 1 oder 2, bei dem die eine Eingabeeinheit ein einziges numerisches Steuerprogramm ist.

4. Verfahren zum Steuern von Datenschreib- und Datenleseoperationen für einen Kassettenspeicher nach Anspruch 1, 2 oder 3, das desweiteren Schritte

zum Erfassen eines Codes, der ein Überwechseln zu dem nachfolgenden Blasen-Kassettenspeicher anzeigt, innerhalb der Operation des Auslesens von Daten aus dem Blasen-Kassettenspeicher, und

zum externen Anzeigen der Tatsachse enthält, daß ein Blasen-Kassettenspeicher zu wechseln ist, wenn der Code erfaßt ist.

5. Verfahren zum Steuern von Datenschreib- und Datenleseoperationen für einen Kassettenspeicher nach einem der vorhergehenden Ansprüche, bei dem die numerischen Steuerdaten in den Blasen-Kassettenspeicher in Einblock-Einheiten eingeschrieben werden.

6. Daten-Schreib/Lese-Steuereinrichtung, angeordnet oder zum Anordnen zwischen einer numerischen Steuereinrichtung und einem Kassettenspeicher, der als ein Hilfsspeicher für ein numerisches Steuersystem zu benutzen ist, zum Einschreiben von numerischen Steuerdaten in den Kassettenspeicher und zum Auslesen von numerischen Steuerdaten aus dem Kassettenspeicher, dadurch gekennzeichnet,

daß der Kassettenspeicher ein Blasen-Kassettenspeicher ist und daß die Einrichtung

Mittel zum Aufteilen einer Eingabeeinheit von Daten, die in den Blasen-Kassettenspeicher von der numerischen Steuereinrichtung her eingeschrieben werden, in eine Vielzahl von Blöcken, wovon jeder aus einer vorbestimmten Anzahl von Bytes besteht,

Mittel zum Addieren eines Steuerbytes zu dem Kopfteil jedes aus der Vielzahl von Blöcken,

Mittel zum Prüfen, ob die Größe des verbleibenden Speicherplatzes in dem Blasen-Kassettenspeicher einem Block von Daten äquivalent ist, und

Mittel zum Einschreiben eines Codes in das Steuerbyte des letzten Blocks enthält, welcher Code ein Überwechseln zu einem nachfolgenden Blasen-Kassettenspeicher anzeigt.

7. Daten-Schreib/Lese-Steuereinrichtung nach Anspruch 6, die desweiteren Mittel zum Leuchtenlassen einer Lampe aufgrund des Erfassens der Tatsache enthält, daß die Größe des verbleibenden Speicherplatzes in dem Blasen-Kassettenspeicher Null ist.

8. Daten-Schreib/Lese-Steuereinrichtung nach Anspruch 6 oder 7, die desweiteren

Mittel zum Abfragen eines Codes, der ein Überwechseln zu dem nachfolgenden Blasen-Kassettenspeicher anzeigt, innerhalb der Operation des Auslesens von Daten aus dem Blasenkassettenspeicher, und

Mittel zum externen Anzeigen der Tatsache enthält, daß ein Blasen-Kassettenspeicher in Reaktion auf das Erfassen des Codes zu wechseln ist.

**Revendications**

1. Méthode pour commander les opérations d'écriture et de lecture de données dans une mémoire à cassette utilisée commee mémoire auxiliaire dans un système de commande numérique, qui comprend un dispositif de commande numérique, la mémoire à cassette elle-même, et un appareil de commande d'écriture/lecture, installé entre le dispositif à commande numérique et la mémoire à cassette, pour écrire des données de commande numérique dans la mémoire à cassette et pour lire des données de commande numérique dans la mémoire à cassette, ladite méthode étant caractérisée par:

la subdivision d'un fichier en une pluralité de blocs comprenant, chacun, un nombre prédéterminé d'octets, cette étape étant exécutée au cours de l'opération d'écriture des données dans une mémoire à cassette qui se trouve être une mémoire à cassette à bulles, par l'appareil de commande d'écriture/lecture, un fichier constituant une seule unité des données écrites dans la mémoire à cassette à bulles à partir du dispositif de commande numérique;

l'addition d'un octet de commande dans la partie d'en-tête de chacun de ladite pluralité des blocs;

la détection recherchant si l'importance du volume de stockage restant dans la mémoire à cassette à bulles équivant à un bloc de données; et

l'ecriture d'un code, signalant le passage à une mémoire à cassette à bulles suivante, dans le dernier octet de commande stocké dans la mémoire à cassette à bulles, cette étape étant exécutée lorsque l'espace de stockage restant dans la mémoire à cassette à bulles est détecté comme équivalent à un seul bloc de données.

2. Méthode pour la commande des opérations d'écriture et de lecture des données pour une mémoire à cassette, selon la revendication 1, comprenant encore une opération signalant extérieurement qu'une mémoire à cassette à bulles doit être changée quand l'importance du volume de stockage restant dans la mémoire à cassette à bulles est zéro.

3. Méthode pour la commande des opérations d'écriture et de lecture des données pour une mémoire à cassette, selon l'une des revendications 1 ou 2, dans laquelle ladite unité d'entrée des données est un seul programme de commande numérique.

4. Méthode pour la commande des opérations d'écriture et de lecture des données pour une mémoire à cassette, selon l'une des revendications 1, 2 ou 3, comprenant encore les opérations suivantes:

détection d'un code, indiquant le passage à ladite mémoire à cassette à bulles suivante, au cours de l'opération de lecture des données dans la mémoire à cassette à bulles, et

signalement à l'extérieur que la mémoire à cassette à bulles doit être remplacée quand ledit code est détecté.

5. Méthode pour la commande des opérations d'écriture et de lecture de données dans une mémoire à cassette, selon l'une quelconque des revendications précédentes, dans laquelle des données de commande numérique sont écrites dans la mémoire à cassette à bulles dans des unités d'un seul bloc.

6. Appareil pour la commande d'écriture/lecture des données prévues ou à prévoir entre un dispositif de commande numérique et une mémoire à cassette à utiliser comme mémoire auxiliaire pour un système à commande numérique, afin d'écrire des données de commande numérique dans la mémoire à cassette et de lire des données de commande numérique dans la mémoire à cassette, caractérisé en ce que ladite mémoire à cassette est une mémoire à cassette à bulles et en ce que ledit appareil comprend:

des moyens pour diviser une unité d'entrée des données, écrites dans la mémoire à cassette à bulles à partir du dispositif à commande numérique, en une pluralité de blocs contenant, chacun, un nombre prédéterminé d'octets;

des moyens pour ajouter un octet de commande dans la partie en-tête de chacun parmi ladite pluralité de blocs;

des moyens de discriminer si l'importance du volume de stockage restant dans la mémoire à cassette à bulles équivaut à un bloc de données; et

des moyens pour écrire un code, signalant le passage à une mémoire à cassette à bulles suivante, dans l'octet de commande du dernier bloc.

7. Appareil pour la commande d'écriture/lecture des données selon la revendication 6, comprenant encore des moyens pour allumer un voyant au moment de la détection du foit que l'importance du volume de stockage restant dans la mémoire à cassette à bulles est égale à zéro.

8. Appareil pour la commande d'écriture/lecture des données selon l'une des revendications 6 ou 7, comprenant encore:

des moyens pour détecter un code, indiquant le passage à une mémoire à cassette à bulles suivante, au cours de l'opération de lecture des données dans la mémoire à cassette à bulles, et

des moyens pour signaler extérieurement que la mémoire à cassette à bulles doit être remplacée en réponse à la détection dudit code.

# Fig. 1

Fig. 2

# Fig. 3

0 049 112

# Fig. 4

4